# EUROPEAN PATENT APPLICATION

(11) **EP 3 813 129 A1**
(43) Date of publication of application: **28.04.2021**
(21) Application number: 19204365.1
(22) Date of filing: 21.10.2019
(51) Int. Cl.: H01L 33/60, H01L 33/48, H01L 33/50, H01L 33/62

(54) **LED MODULE AND METHOD FOR MANUFACTURING THE SAME**

(71) Applicant: Lumileds Holding B.V., 1118 CL Schiphol (NL)
(72) Inventor: The designation of the inventor has not yet been filed
(74) Representative: ter Heegde, Paul Gerard Michel

(57) **Abstract**

The present invention relates to the field of semiconductor technology, and particularly to a LED module and a method for manufacturing the LED module. The LED module comprises a LED die (30) and a substrate (10) for supporting the LED die (30), wherein a first surface (S1) of the substrate (10) comprises a central region (101) for placing the LED die (30), a peripheral region (102) surrounding the central region (101), and a trench (T) separating the central region (101) from the peripheral region (102). During a process of dispensing light reflection materials on the substrate (10) for the LED die (30), the trench (T) would receive and accommodate a certain amount of the light reflection materials that would otherwise flow to the central region (101), thereby blocking the light reflection materials from overflowing to the LED die (30) in the central region (101).

## Description

### FIELD OF THE INVENTION

The present invention relates to the field of semiconductor, and particularly to a LED module and a method for manufacturing the same.

### BACKGROUND OF THE INVENTION

Light emitting devices such as LEDs have been widely used in various electrical devices. A typical LED device is in a form of a LED package (also referred to as LED module) containing a LED die. For a LED device, a high utilization efficiency of light is always an objective which technical researchers have being pursuing. However, some components of the LED device may have a relatively strong light-absorbing property, e.g., a substrate for supporting the LED die and metal wires within the LED package, etc., which is adverse to improving light utilization efficiency for the LED device. An existing way to reduce the light absorption is arranging some light reflection materials to cover the components having strong light-absorbing property of the LED device, so that most of the light emitted from the LED die is reflected and exits the LED package. In order not to affect normal light emission of the LED die, the light reflection materials should not contact the LED die. To this end, a ring-shaped dam is usually disposed on the substrate to surround the area where the LED die is mounted, so as to prevent uncured light reflection materials from flowing to the LED die during the process of dispensing the light reflection materials on the substrate.

### SUMMARY OF THE INVENTION

The inventor of the present invention recognizes that the LED device with the ring-shaped dam is prone to a yellowing phenomenon. Particularly, the dam in the LED device may appear yellowish after the LED device operates for a period of time, which may result in decay in luminous flux of the LED device and be adverse to a service life of the LED device. The inventor realizes two main factors that may cause the yellowing phenomenon. One factor is the light radiation from the LED die, e.g., radiation of blue ray from a blue LED die may cause a white dam around the LED die to become yellowish. Another reason for the yellowing phenomenon is the material for the dam tends to be sensitive to high temperature. For example, the dam around the LED die typically comprises a polymer resin-based compound material, and the dam is easy to become yellowish after being subjected to a high temperature condition required in e.g. a reflow process for mounting the LED device to a printed circuit board (PCB) with surface mounted technology (SMT). In view of this, the present invention provides a LED module having different structures from the existing LED modules, so as to eliminate or at least alleviate one or more of the above mentioned defects.

According to an embodiment of the invention, a LED module comprising a LED die and a substrate for supporting the LED die is proposed. A first surface of the substrate comprises a central region for placing the LED die, a peripheral region surrounding the central region, and a trench separating the central region from the peripheral region. In the LED module proposed by this embodiment, the trench of the substrate makes it possible to cancel the arrangement of the dam around the LED die. Specifically, during the process of dispensing the light reflection materials on the substrate for the LED device, the trench would receive and accommodate a certain amount of the light reflection materials that would otherwise flow to the central region, thereby blocking the light reflection materials from overflowing to the LED die in the central region. That is to say, the trench of the substrate is capable of playing a similar function as the dam in the existing LED device. Therefore, it is not necessary to dispose the dam around the LED die, the defects brought about by the dam could be eliminated. Further, even if some other materials need to be contained in the trench for other profitable purposes, they would be less affected by the light radiation from the LED die and the high temperature during the reflow process, since they are below the LED die and isolated from the LED die by the light reflection material.

The trench of the LED module may have a suitable depth to accommodate a certain amount of light reflection materials around the LED die. In an embodiment, a depth of the trench is greater than or equal to 0.05 mm. Optionally, the depth of the trench may be not less than 0.1 mm.

In an embodiment, a transversal section of the trench perpendicular to the first surface of the substrate has a shape of an arc or a triangle. Trenches having an arc or triangle transversal section may be easy to manufacture, however, trenches having a transversal section of other shapes are also possible.

In an embodiment, the LED module further comprises a barrier protruding from the first surface of the substrate and surrounding the peripheral region. With the barrier protruding from the first surface of the substrate, a space for accommodating some other necessary structures of the LED module can be defined above the substrate. The materials for the barrier can be electrically conductive or electrically non-conductive. In an example, the barrier is formed with white material such as an epoxy molding compound, so that light from the LED die is absorbed as little as possible.

In an embodiment, the body of the substrate comprises both an electrically conductive material and an electrically non-conductive material. The electrically non-conductive material can be combined with the electrically conductive material to form an integral substrate. In an example, the substrate comprises a first conductive patch and a second conductive patch that are electrically connected to an anode and a cathode of the LED die, respectively. Moreover, the first and second conductive patches are electrically isolated from each other, and an electrical isolation between the first and second conductive patches may be partially achieved by a portion of the trench. For example, in an embodiment, the peripheral region of the first surface of the substrate may comprise at least one sub-peripheral region of molding material, a part of the substrate corresponding to the portion of the trench comprises the molding material, and the at least one sub-peripheral region is connected with the portion of the trench to electrically isolate the first conductive patch from the second conductive patch. In other words, the molding material at the sub-peripheral region and the molding material at the portion of the trench mechanically connect the first and second conductive patches together, meanwhile achieve the electrical insulation between the first and second conductive patches. In an embodiment, the molding material comprises an epoxy molding compound. The epoxy molding compound is white and electrically insulating, which is helpful for improving the light utilization efficiency for the LED module. In an example, the barrier is also formed with the epoxy molding compound, and may be fabricated with the sub-peripheral region and the portion of the trench during the same process.

In an embodiment, the LED die is attached within the central region of the substrate, and the trench is spaced apart from the LED die by an annular sub-region of the central region surrounding the LED die. The annular sub-region surrounding the LED die is advantageous to further prevent the light reflection material from reaching the LED die during the process of dispensing the light reflection material on the substrate.

The dispensed light reflection material may form a light reflection layer on the substrate. Accordingly, in an embodiment, the LED module comprises a light reflection layer that covers the peripheral region and the trench of the substrate. The light reflection layer is spaced apart from the LED die by the annular sub-region of the central region.

In an embodiment, a height of the light reflection layer from the first surface of the substrate to an upper surface of the light reflection layer gradually increases from the trench to the barrier.

The light reflection material for the light reflection layer preferably comprises diffuse reflection materials and light scattering materials. In an embodiment, the light reflection layer comprises white silicone.

In an embodiment, the LED module further comprises a light conversion layer covering the LED die and the light reflection layer. The material for the light conversion layer may be selected to cooperate with the light emitted from the LED die to generate a mixed light of desired color that would exit the LED module.

In an embodiment, the substrate is an electrically non-conductive substrate having through holes, the LED module further comprises two conductive pads on a second surface of the substrate opposite to the first surface, an anode and a cathode of the LED die are electrically connected to a respective one of the two conductive pads via the through holes, respectively. For example, the substrate may be a ceramics substrate, and the through holes may be formed in the ceramics substrate by means of any suitable process in the art.

The present invention further provides a method for manufacturing the LED modules as described in the above embodiments. According to an embodiment of the invention, a plurality of LED modules can be manufactured at the same time, the method comprises the following steps: providing a metal plate; performing a patterning process to the metal plate to obtain electrically conductive patches for a plurality of the substrates that are spaced from each other by gaps, the patterning process creating the gaps and the trenches; placing the patterned metal plate into a mold; overmolding the patterned metal plate with a molding material for creating the plurality of substrates, the overmolding creating barriers bridging the gaps, the overmolding creating mechanical connections between the electrically conductive patches being electrically isolated from each other, and the overmolding preserving the trenches; attaching LED dies within the central regions of the plurality of the substrates; electrically connecting the LED dies to the electrically conductive patches; dispensing a light reflection material within the peripheral regions of the plurality of the substrates in a way to avoid the light reflection material spilling over the trenches to the central regions; and singulating the plurality of substrates with the LED dies and the light reflection material into the plurality of the LED modules by dicing at the gaps.

In an embodiment, the performing the patterning process to the metal plate comprises: etching through portions of the metal plate to create the gaps and to obtain the electrically conductive patches separated from each other for each of the plurality of the substrates.

Some embodiments of the invention are generally described above, but it will be appreciated by a person of ordinary skill in the art that two or more of the technical features of the above disclosed embodiments of the invention may be combined in any way deemed useful. Different modifications and variations of the above embodiments of LED modules can be conceived by the person of ordinary skill in the art based on the teaching of the present disclosure.

### BRIEF DESCRIPTION OF THE DRAWINGS

These and other aspects of the present invention will be described now in more detail, with reference to the appended drawings showing embodiments and forming a part of the present invention. Specifically, in the drawings:
- Fig. 1: schematically shows a partial section view of a LED module according to an embodiment of the present invention.
- Fig. 2: schematically shows a partial section view of a LED module according to another embodiment of the present invention.
- Fig. 3: illustrates a top view of a LED module according to an embodiment of the present invention, where the LED die is not shown.
- Fig. 4: illustrates a section view of the LED module taken along a line A-A' in Fig. 3.
- Fig. 5: illustrates a section view of a LED module according to another embodiment of the invention.
- Fig. 6: illustrates a section view of a LED module according to a further embodiment of the invention.
- Fig. 7: illustrates a partial section view of a LED module according to a further embodiment of the invention.
- Figs. 8a to 8j: illustrate steps of a process of manufacturing the LED modules as shown in Fig. 5 according to an embodiment of the disclosure.

### DETAILED DESCRIPTION OF THE EMBODIMENTS

While the present invention is susceptible of embodiments in many different forms, only some specific embodiments are shown in the drawings and will be described in detail herein, with the understanding that the description is to be considered as explanations of the basic principle of the present invention and not intended to limit the present invention only to the specific embodiments shown and described herein.

It should be noted that various components in different figures are not drawn to scale. Besides, relative positional relationships between individual elements shown in the figures are only used to illustrate the basic principle of the present invention and should not be considered to limit the scope of the present invention.

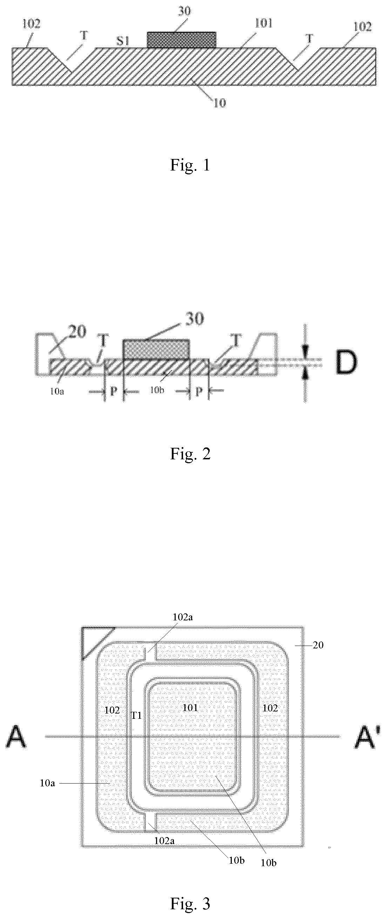

Fig. 1 illustrates a partial sectional view of a LED module according to an embodiment of the invention. The LED module comprises a substrate 10 and a LED die 30 supported on a first surface S1 of the substrate 10. The first surface S1 of the substrate 10 comprises a central region 101 for placing the LED die 30, a peripheral region 102 surrounding the central region 101, and a trench T separating the central region 101 from the peripheral region 102. In an embodiment, the substrate 10 is an electrically non-conductive substrate such as a ceramic substrate. In other embodiments, the body of the substrate 10 may comprise electrically conductive materials. The LED die 30 could be various kinds of semiconductor light emitting chips, including but not limited to a blue LED die that is capable of emitting blue ray when being powered. In the embodiment as shown in Fig. 1, a transversal section of the trench T perpendicular to the first surface T1 of the substrate 10 is in a shape of a triangle, however, the invention is not so limited. The transversal section of the trench T may present any regular or irregular shapes.

Fig. 2 schematically shows a partial section view of a LED module according to another embodiment of the invention. In this embodiment, the transversal section of the trench T perpendicular to the first surface S1 of the substrate 10 has a shape of an arc. The trench having an arc or a triangle transversal section may be relatively easy to fabricate. The LED module further comprises a barrier 20 protruding from the first surface S1 of the substrate 10 and surrounding the peripheral region 102. In an embodiment, the barrier 20 defines a space above the substrate 10 where the additional necessary structures of the LED module would be formed. The barrier 20 may be made from any suitable materials, including electrically conductive materials and electrically insulating materials. In an embodiment, a depth D of the trench T is greater than or equal to 0.05 mm, in other embodiments, the depth D of the trench T may be greater than 0.1 mm. The phrase "depth of the trench" herein means a vertical distance from a lowest point of the bottom of the trench to the first surface of the substrate 10, the depth is indicated with the reference sign "D" in Fig. 2.

For the embodiment shown in Fig. 2, the substrate 10 comprises a first conductive patch 10a and a second conductive patch 10b, the first conductive patch 10a and the second conductive patch 10b are electrically isolated from each other, an electrical isolation between the first conductive patch 10a and the second conductive patch 10b is partially achieved by a portion of the trench T. Although not shown in the figure, the first conductive patch 10a and the second conductive patch 10b may electrically be connected to an anode and a cathode of the LED die 30 respectively, e.g., metal wires may be connected between the anode and the first conductive patch 10a, and between the cathode and the second conductive patch 10b. Thus, when the LED module is in operation, an external power can be supplied to the LED die 30 through the first conductive patch 10a, the second conductive patch 10b and the metal wires. That is to say, in this case, the first conductive patch 10a and the second conductive patch 10b may serve as electrical conductive elements for contacting an external circuit such as a PCB.

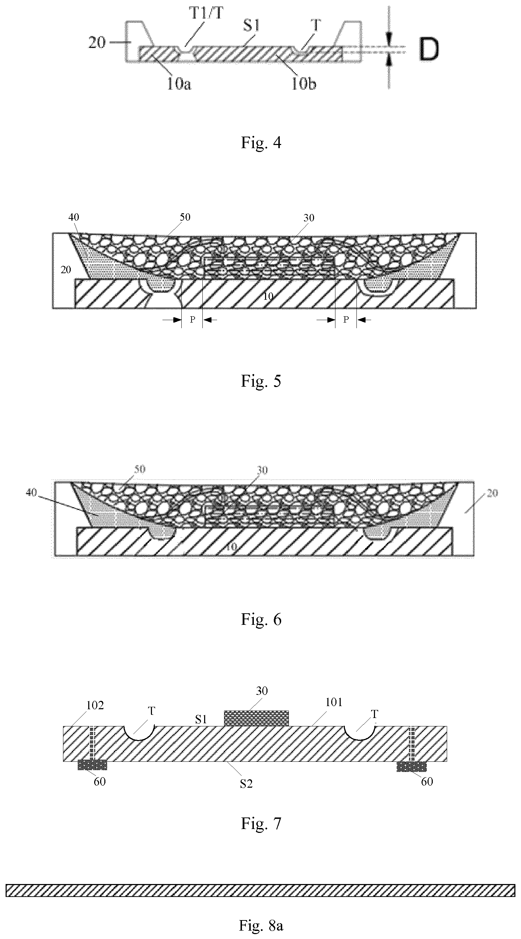

In order to further clarify the above embodiment of the invention, it will be further described by way of examples with reference to Fig. 3 and Fig. 4, where the LED die 30 is not shown for the sake of brevity. Fig. 3 illustrates a top view of a substrate 10 of a LED module according to an embodiment of the invention, and Fig. 4 is a sectional view of the substrate 10 of Fig. 3 taken along the line A-A' in Fig. 3. Referring to Fig. 3, the trench separates the central region 101 from the peripheral region 102, and the peripheral region 102 comprises two sub-peripheral regions 102a. Portions of the substrate 10 corresponding to the sub-peripheral regions 102a may be formed by molding material. In an embodiment, the molding material is an electrically insulating material that can be combined with the first conductive patch 10a and the second conductive patch 10b by means of a molding process. In the embodiment of Fig.3, the two sub-peripheral regions 102a are respectively located at two opposite sides of the substrate 10 and connected with a portion T1 of the trench T. A part of the substrate 10 corresponding to the portion T1 of the trench T comprises the molding material. In this way, the first conductive patch 10a is electrically isolated from the second conductive patch 10b by the portion T1 of the trench T and the two sub-peripheral regions 102a. Though the embodiment of Fig. 3 shows two sub-peripheral regions 102a, in other embodiments, only one sub-peripheral region 102a or more than two sub-peripheral regions 102a may be possible. That is, the electrical isolation between the first conductive patch 10a and the second conductive patch 10b may be implemented in different ways, depending on the specific arrangement of the peripheral region of the substrate. In an embodiment, the sub-peripheral regions 102a comprising the molding material may be flush with the first surface of the substrate 10.

In an embodiment, the molding material comprises resin-based compound materials, e.g., an epoxy molding compound. The epoxy molding compound appears white, which is beneficial for reducing light absorption as much as possible. But the protection scope of the invention is not so limited, in other embodiments, materials in other colors may be used as the molding material.

In an embodiment, an area occupied by the LED die 30 on the first surface S1 of the substrate 10 is smaller than the area of the central region 101, so that the LED die 30 is kept away from the trench T by a suitable distance. Referring back to Fig. 2, in an embodiment, the LED die 30 is attached within the central region 101 of the substrate 10, and the trench T is spaced apart from the LED die by an annular sub-region P of the central region 101 surrounding the LED die 30. In this way, during the subsequent process of forming a light reflection layer on the substrate 10, the risk that the light reflection material for forming the light reflection layer contacts the LED die 30 can be further reduced.

The foregoing embodiments described with reference to figures 1 to 4 mainly focus on the substrate of the LED module. In the following, other components of the LED module will be introduced. As shown in Fig. 5, in an embodiment, the LED module further comprises a light reflection layer 40 covering the peripheral region 102 and the trench T of the substrate 10, the light reflection layer 40 is confined by the barrier 20 and spaced apart from the LED 30 by the annular sub-region P of the central region 101. The light reflection material of the light reflection layer 40 fills the trench T but does not extend beyond an inner edge of the trench close to the LED die. The light reflection layer can be formed by means of any suitable process known in the art. In an example, the light reflection material may be sprayed from a nozzle and stacked on the peripheral region of the substrate. During this process, some light reflection material may flow into the trench T. Here, it can be much easier to understand that the trench T can well prevent the light reflection material from overflowing onto the central region, as the trench T can accommodate some light reflection material that would otherwise flow to the central region. As shown in Fig. 5, the light reflection layer 40 has an uneven thickness or height, specifically, the light reflection layer 40 has a maximum height in the vicinity of the barrier 20, and has a minimum height at the trench T. The phrase "height of the light reflection layer" means a vertical distance from the first surface of the substrate to an upper surface of the light reflection layer. The light reflection layer 40 could be formed from any suitable light reflection materials. The material for the light reflection layer 40 may comprise white materials, including but not limited to white silicone.

Referring to Fig. 5, the illustrated LED module further comprises a light conversion layer 50 covering the LED die 30 and the light reflection layer 40. In an example, the LED die 30 emits a first light with a first wavelength, such as blue light, the light conversion layer 50 is capable of emitting a second light with a second wavelength under excitation of the first light from the LED die 30. In an embodiment, the second light is yellow light, which would mix with the blue light from the LED die to generate white light exiting the LED module. The light conversion layer may comprise any suitable phosphor materials, including but not limited to yttrium aluminum garnet. The specific material for the light conversion layer may be selected depending upon the type of the LED die and the desired light exiting the LED module, which is not limited to the example illustrated herein.

In the embodiment of Fig. 5, the anode and the cathode of the LED die are electrically connected to the first conductive patch 10a and the second conductive patch 10b, respectively. For example, a metal wire may be disposed to connect the anode of the LED die 30 and pass through the light reflection layer 40 to contact the first conductive patch 10a to achieve an electrical connection between the anode and the first conductive patch 10a. Likewise, another metal wire may be disposed between the cathode and the second conductive patch 10b to achieve an electrical connection between the cathode and the second conductive patch 10b.

The above embodiments of the invention do not limit the specific types of the substrate 10. According to another embodiment, the body of the substrate 10 may be made from electrically insulating materials. Referring to the embodiment shown in Fig. 6, the substrate 10 is an electrically non-conductive substrate and does not comprise the above-mentioned molding material. The light reflection layer 40 covers and directly contacts the trench T of the substrate 10. In this case, the LED module may comprise some additional structures to facilitate the electrical connection between the LED die 30 and an external power supply. In an example, as shown in Fig. 7, the electrically non-conductive substrate is provided with two through holes, the LED module further comprises two conductive pads 60 on a second surface S2 of the substrate 10 opposite to the first surface S1, the anode and the cathode of the LED die 30 are electrically connected to a respective one of the conductive pads 60 via the through holes, respectively. For sake of brevity, only the substrate 10, the conductive pads 60, the LED die 30 and the through holes are illustrated in Fig. 7. In an exemplary application, the LED module may be mounted to a PCB below the LED module, and the LED module may be electrically connected to the PCB by means of the conductive pads 60.

Next, a manufacturing process for the LED module proposed by the embodiments of the invention will be described by way of example. Fig. 8a to Fig. 8j illustrate some steps of a method for manufacturing a plurality of LED modules according to the above embodiments. The method would be described by taking manufacturing the LED module as shown in Fig. 5 as an example.

Referring to Fig. 8a, first, a metal plate is prepared. Any kind of metal plates such as a copper plate are possible, the specific forms of the metal plate are not limited herein.

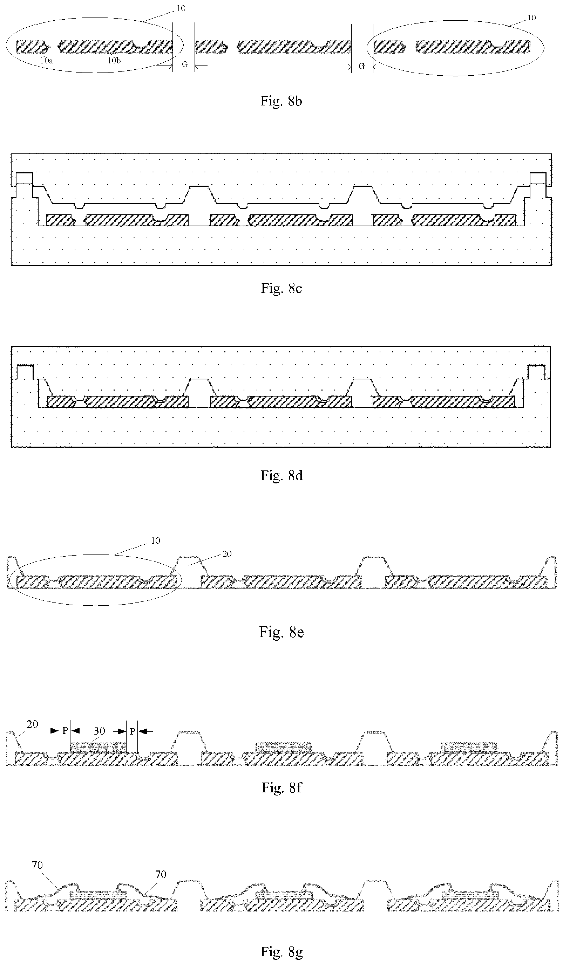

In Fig. 8b, the metal plate undergoes a patterning process to obtain electrically conductive patches 10a, 10b for a plurality of the substrates 10 that are spaced from each other by gaps G. During the patterning process, the gaps G between different substrates 10 of the plurality of the substrates 10 are created, meanwhile, the trenches T of the plurality of the substrates 10 are generated. Therefore, a patterned metal plate is obtained. In an embodiment, the patterning process may involve a chemical wet etching process. However, the invention would not be so limited, the person of ordinary skill in the art could employ any suitable process to form the patterned metal plate. In an example, the patterning process comprises etching through portions of the metal plate to create the gaps G and to obtain the electrically conductive patches 10a, 10b separated from each other for each of the plurality of the substrates 10, as shown in Fig. 8b.

Next, as shown in Fig. 8c and Fig. 8d, the patterned metal plate is placed into a mold and subjected to an overmolding process. The mold may have raised structures corresponding to the trenches T and recess structures corresponding to the created gaps G. The raised structures may substantially match with the trenches. The patterned metal plate may be positioned in the mold such that the raised structures and the recess structures of the mold align with the trenches T and the gaps G in the patterned metal plate, respectively. Thus, the patterned metal plate together with the mold may form a relative small channel between the separated conductive patches 10a, 10b for every single substrate 10 and a relative large channel between two adjacent substrates 10. Then, a molding material may be injected into the channels. As a result, the separated electrically conductive patches 10a, 10b for each substrate 10 can be mechanically connected by the molding material within the small channel, and protruding barriers can be created between adjacent substrates 10 by the molding material filling the large channels. That is, in Fig. 8d, the patterned metal plate is overmolded by the molding material for creating the plurality of substrates 10, the overmolding generates the barriers 20 bridging the gaps G and creates mechanical connections between the electrically conductive patches 10a, 10b for every single substrate 10, and the trenches T of the substrates are preserved. It can be well appreciated that, in practice, the raised structures of the mold may not completely match with the trenches of the substrate, e.g., some small gaps may exist between the raised structures and the trenches of the substrate, the molding material may also flow into these small gaps. Accordingly, in some cases, as shown in Fig. 8d, at least the bottom surfaces of the trenches may be covered with a thin layer of the molding material.

Fig. 8e shows the patterned metal plate that has experienced the above-mentioned overmolding process. It can be seen that the molding material combines the electrically conductive patches 10a, 10b together for every single substrate 10 and forms a barrier 20 for each substrate 10.

In Fig. 8f, a plurality of LED dies 30 are attached within the central regions 101 of the plurality of the substrates 10. Once the LED dies 30 are attached to the substrates 10, sub-peripheral regions P of the central regions are formed around the LED dies 30. In Fig. 8g, the LED dies 30 are electrically connected to the electrically conductive patches 10a, 10b, respectively. For example, for each LED die 30, the anode and the cathode thereof may be connected to the electrically conductive patches 10a and 10b respectively through a metal wire 70. Since the electrically conductive patches 10a and 10b are isolated from each other by the molding material, the LED dies can be electrically connected to an external power and powered normally through the metal wires 70, and the electrically conductive patches 10a and 10b.

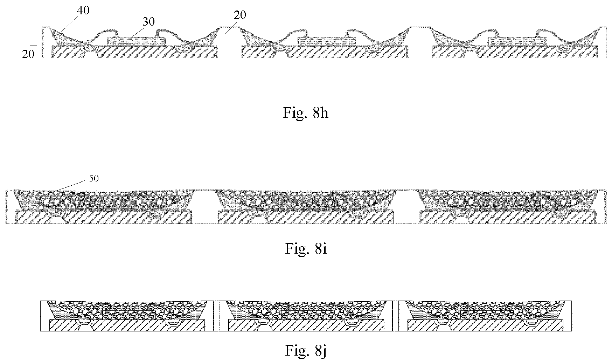

Subsequently, as shown in Fig. 8h, a light reflection material is dispensed onto the plurality of substrates 10. Specifically, the light reflection material is dispensed within the peripheral regions 102 of the plurality of the substrates 10, during which the light reflection material may flow into the trenches T but will not spill over the trenches T to the central regions 101. In an example, the light reflection material such as white silicone may be supplied from a nozzle that is capable of moving relative to the substrate, the speed of movement of the nozzle and the amount of white silicone sprayed from the nozzle can be controlled to form the light reflection layer 40 as shown in Fig. 8h. It can be well appreciated that the trenches T can absorb some light reflection material and facilitate preventing the light reflection material from reaching the central region 101.

Fig. 8i illustrates the light conversion layers 50 have been formed on the substrates 10 to cover the light reflection layers 40 and the LED dies 30. In an example, the light conversion layers 50 are formed by dispensing phosphor gel on the light reflection layers 40 and the LED dies 30.

Finally, as shown in Fig. 8j, a dicing process is performed to obtain individual LED modules. Specifically, the plurality of substrates 10 on which the LED dies 30, the light reflection layer 40 and the light conversion layer 50 have been formed are singulated by dicing at the gaps G. As a result, multiple individual LED modules as shown in Fig. 5 are obtained.

It should also be noted that the above-mentioned embodiments illustrate rather than limit the present invention, and that the person of ordinary skill in the art will be able to design many alternative embodiments without departing from the scope and spirit of the present invention. The scope of the present invention is limited only by the accompanying claims. Additionally, although a feature may appear to be described in connection with particular embodiments, the person of ordinary skill in the art would recognize that various features of the described embodiments may be combined in accordance with the invention.

Furthermore, although individual features may be included in different claims, these may possibly be advantageously combined, and the inclusion in different claims does not imply that a combination of features is not feasible and/or advantageous. In the claims, any reference signs placed between parentheses shall not be construed as limiting the claims. Use of the verb "comprise" and its conjugations does not exclude the presence of elements or steps other than those stated in a claim. The article "a" or "an" preceding an element does not exclude the presence of a plurality of such elements. Also, references to first, second etc. are merely to be considered as labels and do not imply or describe any ordering, sequence, relation or properties of the features prefixed by these terms. The mere fact that certain measures are recited in mutually different dependent claims does not indicate that a combination of these measures cannot be used to advantage.

### LIST OF REFERENCE NUMERALS

- 10: substrate
- 20: barrier
- 30: LED die
- S1: first surface of the substrate
- S2: second surface of the substrate
- 101: central region
- 102: peripheral region
- T: trench
- 10a: first conductive patch
- 10b: second conductive patch
- P: annular sub-region
- T1: portion of the trench
- 102a: sub-peripheral region
- 40: light reflection layer
- 50: light conversion layer
- 60: conductive pads
- 70: metal wires
- G: gaps
- D: depth of the trench

## Claims

1. A LED module comprising a LED die (30) and a substrate (10) for supporting the LED die (30), wherein a first surface (S1) of the substrate (10) comprises:
- a central region (101) for placing the LED die (30),
- a peripheral region (102) surrounding the central region (101), and
- a trench (T) separating the central region (101) from the peripheral region (102).

2. The LED module according to claim 1, wherein a depth of the trench (T) is greater than or equal to 0.05 mm.

3. The LED module according to claim 1, wherein the LED module further comprises a barrier (20) protruding from the first surface (S1) of the substrate (10) and surrounding the peripheral region (102).

4. The LED module according to claim 1, wherein a transversal section of the trench (T) perpendicular to the first surface (S1) of the substrate (10) has a shape of an arc or a triangle.

5. The LED module according to any one of claims 1 to 4, wherein the substrate (10) comprises a first conductive patch (10a) and a second conductive patch (10b) electrically connected to an anode and a cathode of the LED die (30) respectively, wherein the first conductive patch (10a) and the second conductive patch(10b) are electrically isolated from each other, an electrical isolation between the first conductive patch (10a) and the second conductive patch (10b) being partially achieved by a portion (T1) of the trench (T).

6. The LED module according to claim 5, wherein the peripheral region (102) comprises at least one sub-peripheral region (102a) of molding material, a part of the substrate (10) corresponding to the portion (T1) of the trench (T) comprises the molding material, and the at least one sub-peripheral region (102a) is connected with the portion (T1) of the trench (T) to electrically isolate the first conductive patch (10a) from the second conductive patch (10b).

7. The LED module according to claim 6, wherein the molding material comprises an epoxy molding compound.

8. The LED module according to claim 3, wherein the LED die (30) is attached within the central region (101) of the substrate (10), and the trench (T) is spaced apart from the LED die (30) by an annular sub-region (P) of the central region (101) surrounding the LED die (30).

9. The LED module according to claim 8, wherein the LED module further comprises a light reflection layer (40) covering the peripheral region (102) and the trench (T) of the substrate (10), wherein the light reflection layer (40) is spaced apart from the LED die (30) by the annular sub-region (P) of the central region (101).

10. The LED module according to claim 9, wherein a height of the light reflection layer (40) from the first surface (S1) of the substrate (10) to an upper surface of the light reflection layer (40) gradually increases from the trench (T) to the barrier (20).

11. The LED module according to claim 9, wherein the light reflection layer (40) comprises white silicone.

12. The LED module according to any one of claims 9 to 11, wherein the LED module further comprises a light conversion layer (50) covering the LED die (30) and the light reflection layer (40).

13. The LED module according to any one of claims 1 to 4, wherein the substrate (10) is an electrically non-conductive substrate having through holes, the LED module further comprising two conductive pads (60) on a second surface (S2) of the substrate (10) opposite to the first surface (S1), an anode and a cathode of the LED die (30) being electrically connected to a respective one of the two conductive pads (60) via the through holes, respectively.

14. A method for manufacturing a plurality of LED modules according to any one of claims 1 to 12, comprising:
- providing a metal plate;
- performing a patterning process to the metal plate to obtain electrically conductive patches (10a, 10b) for a plurality of the substrates (10) that are spaced from each other by gaps (G), the patterning process creating the gaps (G) and the trenches (T);
- placing the patterned metal plate into a mold;
- overmolding the patterned metal plate by a molding material for creating the plurality of substrates (10), the overmolding creating barriers (20) bridging the gaps (G), the overmolding creating mechanical connections between the electrically conductive patches (10a, 10b) being electrically isolated from each other, and the overmolding preserving the trenches (T);
- attaching LED dies (30) within the central regions (101) of the plurality of the substrates (10);
- electrically connecting the LED dies (30) to the electrically conductive patches (10a, 10b);
- dispensing a light reflection material within the peripheral regions (102) of the plurality of the substrates (10) in a way to avoid the light reflection material spilling over the trenches (T) to the central regions (101), and
- singulating the plurality of substrates (10) with the LED dies (30) and the light reflection material into the plurality of the LED modules by dicing at the gaps (G).

15. The method according to claim 14, wherein the performing the patterning process to the metal plate comprises:
etching through portions of the metal plate to create the gaps (G) and to obtain the electrically conductive patches (10a, 10b) separated from each other for each of the plurality of the substrates (10).
